# EUROPÄISCHE PATENTANMELDUNG

(11) **EP 4 554 060 A1**
(43) Veröffentlichungstag der Anmeldung: **14.05.2025**
(21) Anmeldenummer: 23208604.1
(22) Anmeldetag: 08.11.2023
(51) Int. Cl.: H02K 3/40, H02K 11/20, G01R 31/34

(54) **DYNAMOELEKTRISCHE MASCHINE MIT EINEM TEILENTLADUNGSSENSITIVEN ISOLIERSTOFF**

(71) Anmelder: Innomotics GmbH, 90441 Nürnberg (DE)
(72) Erfinder: Katzenberger, Tobias, 97631 Bad Königshofen STT Untereßfeld (DE); Plochmann, Bastian, 91413 Neustadt an der Aisch (DE)
(74) Vertreter: Siemens Patent Attorneys

(57) **Zusammenfassung**

Die Erfindung betrifft einen Stator (8) und/oder Rotor (9) einer dynamoelektrischen Maschine (1), mit einem in Nuten (16) eines elektromagnetisch leitfähigen Körpers (10) angeordneten, insbesondere mehrphasigen Wicklungssystem (13), das an den Stirnseiten des jeweiligen elektromagnetisch leitfähigen Körpers (10) Wicklungsköpfe (7) ausbildet,
wobei in den Nuten (16) und/oder in dem Wickelkopf (7) zumindest abschnittsweise ein Isolationsmaterial vorgesehen ist, wobei das Isolationsmaterial einen Leiterbahnträger (27) aufweist, der in vorgebbaren Abschnitten einen Verbundwerkstoff (28) mit frequenzabhängigem Widerstandsverhalten vorsieht, um eine spannungsmäßige Überbeanspruchung, insbesondere Teilentladungen in dem Wicklungssystem vor allem im Nut- und/oder Wickelkopfbereich erfassbar zu machen.

## Beschreibung

Die Erfindung betrifft einen Stator und/oder einen Rotor einer dynamoelektrischen Maschine mit einem teilentladungssensitiven Isolierstoff als Nutauskleidung oder Phasentrenner, als auch ein Verfahren zur Bestimmung von Teilentladungen.

Wicklungssysteme insbesondere von Niederspannungsmotoren (Spannung bis 1000 V DOL (Direct-on-line = Netzbetrieb) bzw. 690V VSD (Variable-speed-drive = Umrichterbetrieb) in Statoren und/oder Rotoren werden gesehen mit einem elektrischen Isolationssystem ausgestattet, welches gemäß gängiger IEC-Normen Teilentladungs-frei sind. Dieses Isolationssystem besteht aus dem Drahtlack, welcher herstellerseitig bereits auf den Kupferdraht aufgebracht wird (ca. 200pm) und aus einem Multilagenaufbau z.B. PAI (Polyamidimid) besteht sowie einem sogenannten Nutkasten als Hauptisolation, welcher standartmäßig eine Art U-förmig gefalztes Papier ist. Dieser besteht zumeist aus dem kommerziellen Laminat-Material, welches innenliegend eine PET-Folie (200 µm; Polyethylenterephthalat) aufweist, welche mit Aramidfasern (Aramidfilz) beidseitig beschichtet ist.

Im Fertigungsverlauf, z.B. eines Stators einer dynamoelektrischen Maschine, werden zuerst Nutauskleidungen in die Nuten des Blechpakets eingesetzt und im Anschluss, insbesondere vorgewickelte Kupferdrahtwicklung, mechanisch in die Nuten eingezogen.

Im Anschluss werden im Bereich der Wickelköpfe an den Stirnseiten des Stators noch die einzelnen Phasen durch Einlege-Papiere, sogenannten Phasentrennern zueinander isoliert.

Nach dem Formen der Wickelköpfe und deren Bandagierung kommt ein Imprägnierprozess zur Anwendung (Kalttauchen, Heißtauchen oder Träufeln), wodurch die Drahtzwischenräume, die Räume vor und hinter den Nutauskleidungen sowie die geometrischen Zwickel in den Wickelköpfen zumindest teilweise mit Imprägnierharz (PEI, Polyetherimid oder Epoxy) gefüllt werden. Dieses Imprägnierharz soll primär die mechanische Fixierung und Entwärmung der Kupferdrähte sicherstellen und eignet sich im Normalfall nur bedingt als elektrische Hauptisolierung.

D.h. das Isoliersystem eines Stators einer dynamoelektrischen Maschine besteht im Querschnitt betrachtet von (Hoch-) Spannung zu Erde im Grunde aus Drahtlack, Imprägnierung (sehr porös), Nutauskleidung, und Imprägnierung (sehr porös).

Hierbei kann das Isoliersystem als Kondensator mit verschiedenen dielektrischen Werkstoffen vereinfacht betrachtet werden, wobei die elektrischen Feldlinien immer in Bereiche niedrigen εᵣ verdrängt werden, was im Zweifel immer eine Luftpore, bzw. ein unvollständig ausgehärteter Harzbereich im Isoliersystem ist.

Ein derartiges Isoliersystem erfüllt die Anforderungen hinsichtlich der Betriebsspannung der dynamoelektrischen Maschine normalerweise ausreichend was Durchschlagsfestigkeit, Isolationswiderstand, und Verlustfaktor anbelangt.

Die dynamoelektrischen Maschinen, insbesondere Motoren werden kundenseitig allerdings immer häufiger an Umrichtern betrieben, wodurch es bei deren steilflankigen Schaltvorgängen (Rechteckspannungen) mit Anstiegsflanken im Bereich von bis zu 150ns und kleiner zu deutlichen Spannungs-Überschwingern bei den ständigen Schaltvorgängen des Umrichters kommt. Grund dafür ist, dass elektrotechnisch eine solche scharfe Flanke mittels Überlagerungen von sehr hohen Frequenzen (1kHz bis in den Megahertzbereich) erzeugt werden. Diese Überschwinger haben teilweise eine vielfache Amplitude des eigentlichen Spannungs-Sollwerts und laufen mit der spezifischen Pulslaufzeit durch die Wicklungen der elektrischen Maschinen (Wanderwelleneffekte). Bei diesen Wanderwelleneffekten werden die Pulse innerhalb der Spulen aufgrund der ohmschen Widerstände und Induktivitäten abgebaut, wodurch es zu einer Spannungsdifferenz von teilweise einem Vielfachen der Betriebsspannung zwischen den ersten Windungszahlen und den letzten Windungszahlen einer Spule in einer Nut kommt, welche ausschließlich durch den Drahtlack und die qualitativ teilweise nur mäßige Imprägnierung voneinander getrennt sind. Je kleiner diese Anstiegszeit sind, desto höher ist die Belastung für das Isoliersystem der dynamoelektrischen Maschine.

Durch das Prinzip einer "wilden Wicklung" kann es im Fertigungsprozess des Bewickelns des Stators vorkommen, dass niederzahlige Windungen und hochzahlige Windungen - also Windungen am Spuleneingang und Spulenausgang - sich direkt berühren und überkreuzen.

Dies ist in der Regel gar nicht oder nur durch sehr hohen händisch Aufwand zu verhindern bzw. zu korrigieren. Dasselbe Problem ergibt sich zwischen Phasen und Blechpaket (Erdpotential), bzw. zwischen zwei unterschiedlichen Phasen, was allerdings bei fachgerechter Anbringung der Nutauskleidung, bzw. der Phasenisolation im Wickelkopf deutlich geringere Einflüsse hat.

Häufig vorhandene Fertigungsprobleme durch Verrutschen von Flächenisolierstoffen z.B. in einer Nut oder im Wickelkopf wirken sich hierdurch allerdings besonders negativ aus.

Die oben beschriebenen Überspannungen übertreffen dann häufig bei den oben beschriebenen Konstellationen die Einsetzspannung von Teilentladungen (TEs) im Isolationssystem (meist Draht-Draht), welche durch Poren, Hohlräume und Materialwechsel (unterschiedliches εᵣ) an Schwachpunkten existiert.

Überspannungen zwischen isolierten elektrischen Leitern können insbesondere die Isolierung der Leiter beeinträchtigen.

Ein Isoliersystem weist somit typischerweise fertigungsbedingte Fehlstellen in Form von Poren und Spalten mit Ausdehnungen im Mikrometer- bis Millimeterbereich auf. Überspannungen können somit in einer Isolierung Teilentladungen verursachen, die aufgrund der meist niedrigeren Dielektrizitätskonstante vor allem in derartigen Fehlstellen gemäß dem Paschen-Gesetz ab einer gewissen Feldstärke des elektrischen Feldes durch einen Lawineneffekt von Ladungsträgern zünden. Durch derartige Teilentladungen wird die Isolierung vor allem im Bereich von Fehlstellen sukzessive verschlechtert, bis es zum Ausfall der Isolierung kommt.

Es kommt somit über das Paschen-Minimum zum Einsetzen von Teilentladungen. Diese Teilentladungen zünden dann im Umrichterbetrieb fortlaufend und werden durch damit fortschreitende "Erosion" des Isolationsmaterials weiter verstärkt, wodurch es relativ zeitnah sogar zum Ausfall des Isolationssystems und somit zu einem Motordefekt kommt.

Drahtkreuzungen in einem Wickeleinziehautomat, welcher eine wilde Wicklung in die Nuten einzieht, sind nicht zu vermeiden, genauso wenig wie Schwachstellen im insbesondere kostenoptimierten Imprägniersystem zu vermeiden sind.

Es bleibt nur die Möglichkeit einer TE-Prüfung, welche im Zweifel nicht bestanden wird und somit der Motor als defekt aussortiert werden muss. Dies ist allerdings nur für Maschinen anwendbar, welche bereits vor Auslieferung eine deutliche Schwachstelle aufweisen.

Typischerweise sind dies jedoch "schleichende" Prozesse, welche sich erst nach einiger Zeit im Betrieb der dynamoelektrischen Maschine signifikant verändern und somit bei der Qualitätskontrolle im Werk (zunächst) als gut befunden werden.

Die Qualität und der Zustand der Isolierung eines Wicklungssystems einer dynamoelektrischen Maschine ist von außen in der Regel nicht quantitativ feststellbar, so dass ein Totalausfall der dynamoelektrischen Maschine durch einen von einer aufgrund von TEs einstellenden Isolierungsschädigung verursachten elektrischen Durchschlag, beispielsweise zwischen den Windungen zweier verschiedener Phasen der Maschine oder zwischen einer Windung und einem geerdeten Blechpaket, derzeit nicht prognostizierbar ist.

Andere Wicklungsmethoden zur Vermeidung von derart verursachten Teilentladungen, wie z.B. Nadelwicklung, sind deutlich teurer in der Anschaffung, schränken den Freiheitsgrad in der Varianzbeherrschung der dynamoelektrischen Maschinen deutlich ein und haben zudem eine höhere Zykluszeit, was letztlich den Fertigungsprozess ebenfalls verteuert und somit die Herstellung vor allem eines Standardmotor oftmals unwirtschaftlicher macht.

Eine sehr hochwertige Imprägnierung, d.h. eine nahezu 100% Füllung der Draht/Nutauskleidung-Zwischenräume würde das elektrische Feld aus den kritischen Bereichen verdrängen (εᵣ) und somit das Paschenminimum verschieben. Somit wäre die TE-Einsetzspannung erhöht und die Wahrscheinlichkeit von TE Problemen am Umrichter verringert. Eine solche Imprägnierung ist jedoch praktisch (wirtschaftlich) nur schwer zu realisieren, da Methoden, wie VPI (Vakuum pressure impregantion) und Vollverguss einen deutlich höheren Fertigungs- und Materialpreis hätten und auch hier keine vollständige Harzfüllung garantiert werden kann.

Demnach besteht ein resultierendes "TE-Problem", das sich u.a. besonders im Wickelkopf zwischen zwei kritischen sich berührenden Drähten oder in den Nuten zwischen Drähten und geerdetem Blechpaket zeigt.

Ist die TE-Einsetzspannung, die sich aus der Drahtisolierung der beiden Drähte, dem Imprägnierharz, den Isolierpapieren (Nutkasten oder Phasentrenner) und evtl. Lufteinschlüsse ergibt, überschritten kommt es zu diesen sogenannten Teilentladungen (TEs).

Aufgrund häufigen Auftretens dieser Entladungen (im ungünstigsten Fall bei jedem Spannungsimpuls des Umrichters) baut sich die Drahtisolierung und generell das Isoliersystem sukzessive ab, bis es zur vollständigen Entladung, dem Durchschlag, kommt. Nun herrscht ein Kurzschluss zwischen den betroffenen Windungen bzw. des Drahtes und dem Blechpaket (Erde). Das hat zur Folge, dass an dieser Stelle aufgrund des Kurzschlussstromes die Temperatur deutlich ansteigt bis die betroffenen Drähte "durchbrennen".

Der Motorstrom wird unsymmetrisch und die Wicklung brennt als Folge komplett durch oder aber der Umrichter erkennt die Unsymmetrie und schaltet ab. In beiden Fällen ist der Motor defekt und meist irreparabel.

Ein Erkennen von Fehlstellen und dadurch resultierenden Teilentladungen ist also immer erst dann möglich, wenn die Maschine bereits defekt ist.

Es gibt somit aktuell motorseitig zwei Möglichkeiten dem Ausfall vorzubeugen:
Deutlich teurere Fertigungsverfahren nutzen, wie oben beschrieben, oder
Warenausgangsprüfungen durchführen und eine dementsprechend hohe Ausschussquote akzeptieren bzw. das Isoliersystem zu Lasten der Kosten und der resultierenden reduzierten Kupferfüllung in der Nut deutlich zu verstärken.

Kundenseitig gibt es ebenfalls die Möglichkeit Filter einzusetzen, welche die Anstiegszeiten der Umrichterflanken vergrößern und somit die Überschwinger reduzieren. Jedoch handelt es sich hierbei um teure Anschaffungen für den Kunden und diese Filter haben einen negativen Einfluss auf den Gesamtwirkungsgrad des Systems Motor-Umrichter, da sie "in Reihe" geschalten werden.

Aus der EP 3 505 943 A1 ist eine Nachweisvorrichtung bekannt, die auftretende Überspannungen im elektrischen Netz misst, welche bei einem mangelhaftem Isoliersystem des Motors zu Teilentladungen führen können. Es handelt sich also um eine indirekte Bestimmung eines möglicherweise schadhaften Isoliersystems, wobei die Nachweisvorrichtung zwischen den Phaseneingängen und -ausgängen sowie zwischen den jeweils einzelnen Phasen und den Phasen und dem Erdpotential angebracht ist.

Ausgehend davon liegt der Erfindung die Aufgabe zugrunde, einen Stator und/oder Rotor einer dynamoelektrischen Maschine zu schaffen, die eine ortsabhängige Detektion von unabhängig von der elektrischen Last auftretenden Teilentladungen direkt innerhalb der Isolation ermöglicht.

Die Lösung der gestellten Aufgabe gelingt durch die Merkmale der unabhängigen Ansprüche.

Vorteilhafte Ausgestaltungen der Erfindung sind Gegenstand der abhängigen Ansprüche.

Erfindungsgemäße Grundlage des Stators und/oder Rotors einer dynamoelektrischen Maschine, mit einem in Nuten eines elektromagnetisch leitfähigen Körpers, vor allem eines Blechpakets angeordneten, insbesondere mehrphasigen durch elektrische Leiter gebildeten Wicklungssystem, das an den Stirnseiten des jeweiligen elektromagnetisch leitfähigen Körpers Wicklungsköpfe ausbildet, bildet ein in den Nuten und/oder in dem Wickelkopf zumindest abschnittsweise angeordneten Isolationsmaterial. Dieses Isolationsmaterial weist einen Leiterbahnträger aufweist, der in vorgebbaren Abschnitten einen Verbundwerkstoff mit frequenzabhängigem Widerstandsverhalten vorsieht, um spannungsmäßige Überbeanspruchungen, insbesondere Teilentladungen in dem Wicklungssystem vor allem in diesem Bereich (Nut/Wickelkopf, etc.) erfassbar zu machen.

Dabei weist das Isolationsmaterial partikuläre, elektrisch teilleitfähige Schichten auf, die aus mikroskopischen Partikeln (z.B. SnO2 ggf. dotiert mit Sb, I, F oder SiC, plättchenförmig oder globular, mit Substrat oder ohne, 1 bis 50pm Größe) und einer beliebigen Kunststoffmatrix bestehen, in die die Partikel überperkolär eingebracht sind und somit ein elektrisch leitfähiges Netzwerk bilden.

Dabei wird dieser Verbundwerkstoff mittels einer geeigneten Matrix zu einer Paste ausgestaltet, welche mittels herkömmlicher Verfahren für "printable electronics" wie Siebdruck oder Dispensieren auf das Isolationsmaterial, also den oben genannten Nutkasten oder/und den Phasentrenner jeweils als Substrat appliziert wird und somit eine Leiterbahnstruktur erstellt, welches Isolationsmaterial direkt in der dynamoelektrischen Maschine (z.B. in der Nut und/oder im Wickelkopf) positioniert ist.

Es liegt also beispielsweise eine Leiterbahnstruktur, bestehend aus den oben genannten Partikeln in Verbindung mit einer beliebigen Kunststoffmatrix vor, welche das Drucken und Härten (durch thermische Erhitzung und/oder UV-Vernetzung) zulässt, wie zum Beispiel Polysiloxane, Polyester oder Epoxys. Die Leiterbahnstruktur weist dabei insbesondere eine Schichtdicke von 10pm bis 200 µm und eine Kanten- und Radiengenauigkeit von 50 µm auf. Die Leiterbahnen selbst weisen eine Breite von 100 bis 2000 µm auf.

Die erfindungsgemäßen Verbundwerkstoffe weisen einen elektrischen Widerstand von ca. 10^2 bis 10^5 Ohm (Quadratwiderstand, d.h. ca. 1 Ohmcm bis 100 Ohmcm spezifischer ohmscher Widerstand) bei niedrigen Frequenzen (bis 1000 Hz) auf, wodurch sich bei einer Struktur mit dünnen Linien ein gut auslesbarer Gesamtwiderstand ergibt, jedoch diese teilleitfähige Struktur keinen messbaren Einfluss auf das elektromagnetische Feld im Bereich zwischen Blechpaket und Kupferleitern hat, da es bei vergleichsweise geringen Frequenzen (bis 1 kHz) deutlich zu hochohmig ist.

Diese Ausgestaltung berücksichtigt, dass bei der Herstellung der Leiterbahnen, beispielsweise durch Bedrucken des Leiterbahnträgers, ein Lösemittel erforderlich ist, das nach dem Aufbringen der Leiterbahn abgedampft wird. Bei einer zu gro-ßen Dicke der Leiterbahnen führt das Abdampfen des Lösemittels zu Rissen oder Poren in den Leiterbahnen, die deren Qualität beeinträchtigen. Eine Dicke von etwa 100um ist ein typischer Wert, bei dem die Leiterbahnen eine ausreichende elektrische Leitfähigkeit aufweisen und nicht durch das Abdampfen des Lösemittels beeinträchtigt werden.

Unter dem auch als Quadratwiderstand bezeichneten elektrischen Flächenwiderstand einer elektrisch leitfähigen Schicht wird deren spezifischer Widerstand für eine definierte Schichtdicke verstanden. Ein elektrischer Flächenwiderstand von höchstens 100 kΩ ist bei einer Leiterbahndicke von etwa 100 um vorteilhaft, da andernfalls ein wesentlicher Teil der Überspannung bereits in den Leiterbahnen abgebaut wird.

Die Leiterbahnen weisen beispielsweise jeweils eine Dicke von etwa 100um und einen elektrischen Flächenwiderstand, der vor einer Teilentladung höchstens 100 kΩ beträgt, auf. Die Leiterbahnen werden beispielsweise durch ein Siebdruck- oder Dispenserdruckverfahren auf den Leiterbahnträger aufgebracht.

Da es sich um eine partikuläre Struktur mit vielen Partikelkontaktübergängen und Korngrenzen handelt, welche jede für sich hochohmig sind und eine Art Kapazität darstellen, ist eine frequenzabhängige Widerstandserniedrigung vorhanden, welche durch eine Impedanzspektroskopie gemessen werden kann.

Die Struktur auf dem Isolationsstoff selbst kann hierbei aus linear angeordneten Leiterbahnen, gekreuzten Leiterbahnen oder schlangenförmig verlegten Leiterbahnen auf dem Nutkasten, bzw. dem Phasentrenner bestehen und an den Rändern des Isolationsstoff, z.B. über Kontaktpads abgreifbar sein. Widerstandsveränderung hervorgerufen durch Teilentladungen können somit detektiert werden. (z.B. am Kragenfalz des Nutkastens, welcher sich axial außerhalb des Blechpakets befindet).

In einer Ausgestaltung kann durch eine Leiterbahnanordnung, welche einer Antennenstruktur entspricht, zudem ein Signal eingefangen werden, bzw. ein auf die Phasen des Motors aufmoduliertes Signal elektrisch beeinflusst werden, sodass sich dessen Resonanz ändert, sobald die Leiterbahnstruktur durch Teilentladungen partiell hochohmig wird. Somit ist eine Art elektromagnetischer Schwingkreis zwischen Motorphasen und Leiterbahnstruktur geschaffen, welcher durch die "TE-Belastung" und somit die Widerstandserhöhung der Leiterbahnstruktur seine Resonanzfrequenz ändert, was wiederum, insbesondere über Kontaktpads messbar und über ein geeignetes Auswertetool auswertbar ist.

Dadurch, dass im Bereich des Umrichter-Schaltvorgangs Überschwinger mit sehr hohen Frequenzen (>1kHz) bei gleichzeitig einem Vielfachen der eigentlichen Spannungen ankommen, wird die Verbundwerkstoffschicht, welche die gedruckte Leiterbahn darstellt durch den widerstandserniedrigenden Effekt bei hohen Frequenzen deutlich leitfähiger als für die niederfrequenten Anteile mit geringerer Spannung. Somit ergibt sich zudem in der Leiterbahnschicht ein Polarisationseffekt, welcher TEs bevorzugt in die erfindungsgemäßen Schichten lenkt und somit, wie oben beschrieben auslesbar macht.

Teilentladungen bei einer dynamoelektrischen Maschine entstehen vor allem innerhalb der Nut zwischen einem Kupferdraht und dem Erdpotential (also durch den Nutkasten hin zum geerdeten Blechpaket von Stator oder Rotor) oder aber im Wickelkopf an Berührstellen von kleinen und großen Windungszahlen oder unterschiedlicher Phasen.

Somit ist sichergestellt, dass auftretende Teilentladungen immer in unmittelbarer Nähe der erfindungsgemäß beschichteten (Flächen)-Isolierstoffe auftreten und in der Regel auch direkt mit der Leiterbahnstruktur interagieren und somit die freiwerdende Energie und das Oxidationspotential (Temperatur, UV-Licht, Ozon) die erfindungsgemäßen Leiterbahnen irreversibei hochohmig verändern und somit durch die Widerstandsverschiebung auslesbar machen.

Durch eine geschickte Anordnung und Ausgestaltung der Leiterbahnenstruktur, wie parallele, mäandernde oder engmaschige Verlegung, ist eine einstellbare und damit exakte Ortsauflösung der auftretenden Teilentladungen und damit Schwachstellen des Isoliersystems möglich.

Die in der EP 3 505 943 A1 dargestellt Lösung ist lediglich eine indirekte Methode, um Überspannungen zu detektieren, welche im Motor, bei einem ggf. mangelhaften oder schadhaften Isoliersystems zu Teilentladungen führen können.

Die hier offenbarte Lösung erzeugt eine elektrisch auslesbare Sensorik, welche direkt auftretende Teilentladungen in der Nut oder im Wickelkopf des Motors detektieren kann, unabhängig davon welche Spannungen oder Lastspitzen am Motor anliegen.

Erfindungsgemäß erfolgt also über eine Widerstandserhöhung der Leiterbahnen eine Detektion einer - aufgrund der TEs erfolgten - Reduzierung der Isolationsfestigkeit.

Es kann also z.B. als Qualitätskontrolle am Ende des Fertigungsprozesses verwendet werden oder als Predictive Maintainance Sensorik im Betrieb der dynamoelektrischen Maschine beim Kunden.

Die Erfindung sowie weitere vorteilhafte Ausgestaltungen der Erfindung werden anhand prinzipiell dargestellter Ausführungsbeispiele näher erläutert, darin zeigen:
- FIG 1: eine dynamoelektrische Maschine im Längsschnitt,
- FIG 2: einen Querschnitt einer Nut des Stators,
- FIG 3: Anordnung eines Nutkastens in einem Blechpaket des Stators,
- FIG 4 bis 7: Ausgestaltungen von verschiedenen Nutkästen,
- FIG 8, 9: verschiedene Wickelköpfe,
- FIG 10: schematische Darstellung zweier Füllstoffpartikel eines in eine Kunststoffmatrix eingebetteten Füllstoffes und Energiebänder des Füllstoffes.

Es sei angemerkt, dass sich Begriffe wie "axial", "radial", "tangential" etc. auf die in der jeweiligen Figur bzw. im jeweils beschriebenen Beispiel zum Einsatz kommende Achse 6 beziehen. Mit anderen Worten beziehen sich die Richtungen axial, radial, tangential stets auf eine Achse 6 des Rotors 9 und damit auf die entsprechende Symmetrieachse des Stators 8. Dabei beschreibt "axial" eine Richtung parallel zur Achse 6, "radial" beschreibt eine Richtung orthogonal zur Achse 6, auf diese zu oder auch von ihr weg, und "tangential" ist eine Richtung, die in konstantem radialem Abstand zur Achse 6 und bei konstanter Axialposition kreisförmig um die Achse 6 herum gerichtet ist. Der Ausdruck "in Umfangsrichtung" ist mit "tangential" gleichzusetzen.

In Bezug auf eine Fläche, bspw. eine Querschnittsfläche, beschreiben die Begriffe "axial", "radial", "tangential" etc. die Orientierung des Normalenvektors der Fläche, d.h. desjenigen Vektors, der senkrecht auf der betroffenen Fläche steht.

Unter dem Ausdruck "koaxiale Bauteile", bspw. koaxiale Komponenten wie Rotor 9 und Stator 8, werden hier Bauteile verstanden, die gleiche Normalenvektoren aufweisen, für die also die von den koaxialen Bauteilen definierten Ebenen parallel zueinander sind. Des Weiteren soll der Ausdruck beinhalten, dass die Mittelpunkte koaxialer Bauteile auf der gleichen Rotations- bzw. Symmetrieachse liegen. Diese Mittelpunkte können jedoch auf dieser Achse ggf. an verschiedenen axialen Positionen liegen und die genannten Ebenen also einen Abstand >0 voneinander haben. Der Ausdruck verlangt nicht zwangsläufig, dass koaxiale Bauteile den gleichen Radius haben.

Der Begriff "komplementär" meint im Zusammenhang mit zwei Komponenten, welche "komplementär" zueinander sind, dass ihre äußeren Formen derart ausgestaltet sind, dass die eine Komponente vorzugsweise vollständig in der zu ihr komplementären Komponente angeordnet werden kann, so dass sich die innere Oberfläche der einen Komponente und die äußere Oberfläche der anderen Komponente idealerweise lückenlos bzw. vollflächig berühren. Konsequenterweise ist also im Falle von zwei zueinander komplementären Gegenständen die äußere Form des einen Gegenstandes durch die äußere Form des anderen Gegenstandes festgelegt. Der Begriff "komplementär" könnte durch den Begriff "invers" ersetzt werden.

Der Übersichtlichkeit wegen werden in den Figuren teilweise in den Fällen, in denen Bauteile mehrfach vorhanden sind, häufig nicht sämtliche dargestellten Bauteile mit Bezugszeichen versehen.

Die beschriebenen Ausführungen können beliebig kombiniert werden. Ebenso sind auch Einzelmerkmale der jeweiligen Ausführungen kombinierbar, ohne das Wesen der Erfindung zu verlassen.

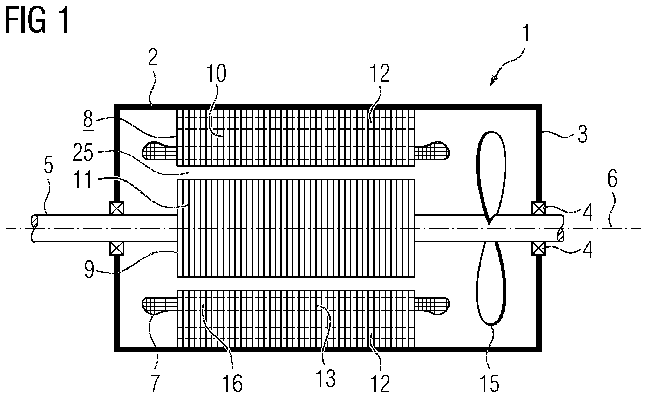

FIG 1 zeigt einen prinzipiellen Längsschnitt einer dynamoelektrischen Maschine 1. Ein Stator 8, mit einem, in im Wesentlichen axial verlaufenden Nuten 16 angeordneten Wicklungssystem 7, ist in diesem Beispiel in einem Gehäuse 2 angeordnet. Über Lagerschilde 3 stützt sich das Gehäuse 2 mittels Lager 4 auf einer Welle 5 ab. Durch einen Luftspalt 25 vom Stator 8 beabstandet, ist ein Rotor 9 vorgesehen, der in im Wesentlichen axial verlaufenden Ausnehmungen Permanentmagnete aufweist. Der Rotor 9 kann auch als Alu/Kupfer/Hybrid-Druckgussläufer ausgebildet sein, oder als Reluktanzläufer.

Sowohl die Blechpakete 10, 11 von Stator 8 und Rotor 9 können optional axial verlaufende Kühlkanäle aufweisen, um auf diese Weise einen geschlossenen Innenkühlkreislauf innerhalb des Gehäuses 2 zu ermöglichen. Bei Bestromung des Wicklungssystems 7 des Stators 8 wird durch elektromagnetische Wechselwirkung mit dem Rotor 9 die Welle 5 um eine Achse 6 in Drehung versetzt. Diese Drehung bewirkt einen Antrieb einer nicht dargestellten Arbeitsmaschine und eines Eigenlüfters 15 in oder am Gehäuse 2.

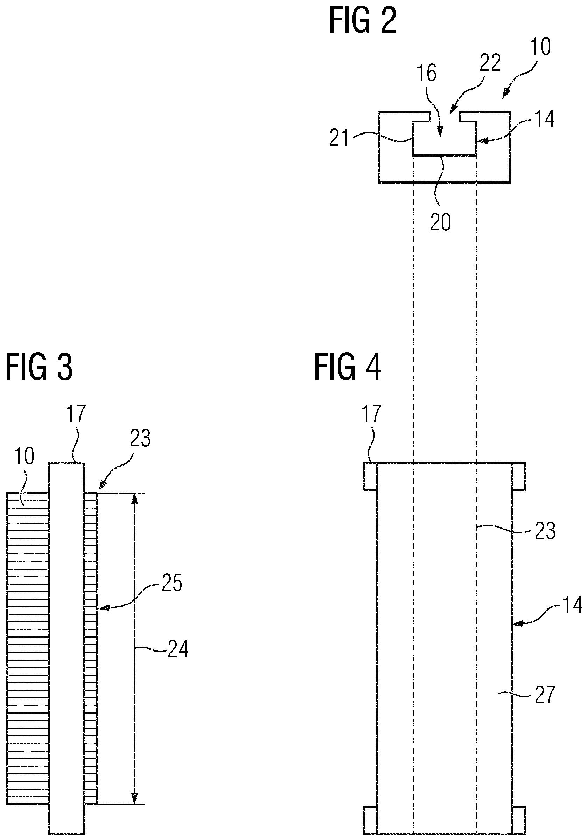

FIG 2 zeigt in einem Querschnitt einer Nut 16 des Stators 8 eine Nutauskleidung, insbesondere einen Nutkasten 14 aus einem Isolationswerkstoff. Der Nutkasten 14 wird entweder axial in die Nut 16 eingeschoben oder über den Nutschlitz 22 in der Nutpositioniert. Der Nutkasten 14 ragt - wie in FIG 3 dargestellt - axial über die Stirnseiten der axialen Länge 24 des Blechpakets 10 des Stators 8 und bildet dort jeweils einen Kragenfalz 17.

Nach FIG 4 weist der Nutkasten 14 vorgesehene Knickbereich 23 auf, um die Montage in der Nut 16 zu erleichtern.

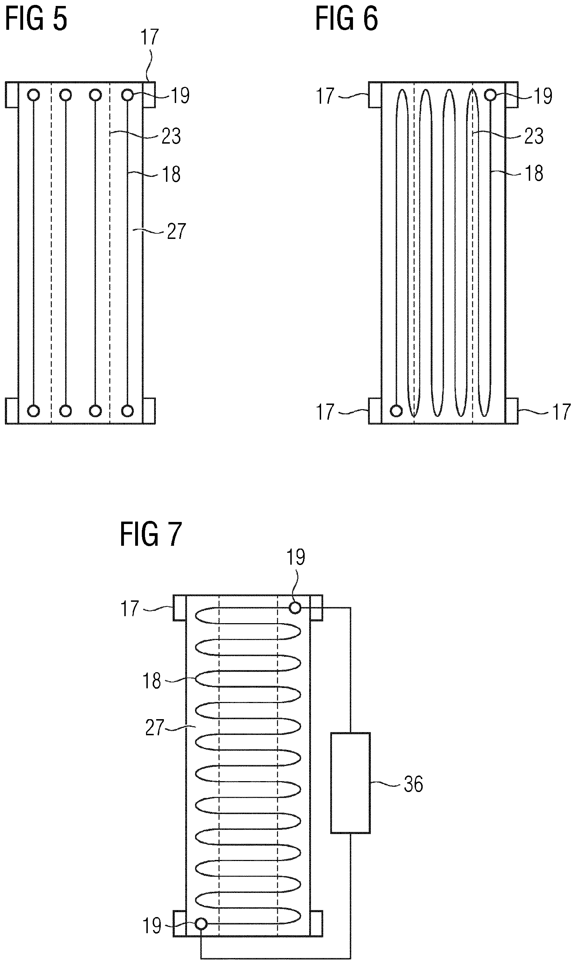

Nach den Figuren 5 bis 7 sind auf dem Kragenfalz 17 Kontaktpads 19 vorgesehen, um über eine Messordnung die Widerstandsänderungen erfassen zu können.

Der Verlauf von Leiterbahnen 18 auf dem Leiterbahnträger 27 eines Nutkastens 14 ist den Figuren 5 bis 7 zu entnehmen und zeigt parallel verlaufenden Leiterbahnen 18 mit jeweils zugewiesenen Kontaktpads 19, als auch auf verschiedenste Arten mäandernder Leiterbahnen 18.

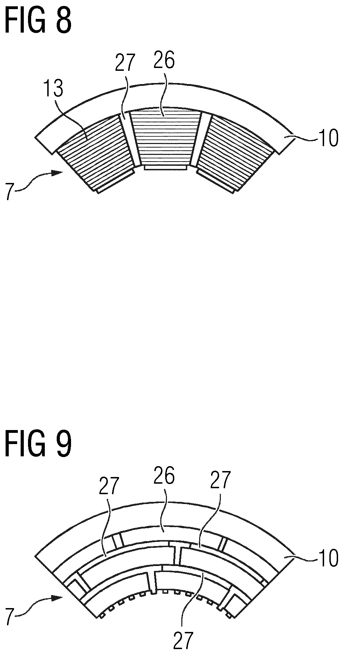

Das Material dieser Leiterbahnträger 27 ist auch als Phasentrenner im Wickelkopf zweier aneinander liegenden unterschiedlichen Phasen oder Spulengruppen einsetzbar. Diese Phasentrenner können bei einem Wickelkopf 7 eines aus Zahnspulen aufgebauten Wicklungssystem 13 (FIG 8), als auch bei einem Wickelkopf 7 eines gesehnten Wicklungssystems 13 (FIG 9) eingesetzt werden.

Beispielsweise sind die Leiterbahnen 18 aus einem Verbundwerkstoff 28 gefertigt, der eine elektrisch nichtleitende Kunststoffmatrix 32 und einen darin eingebetteten Füllstoff 29, durch den der Verbundwerkstoff 28 elektrisch leitfähig ist, umfasst.

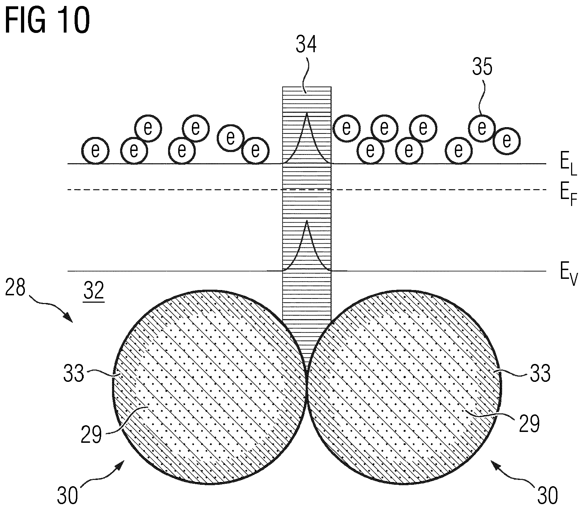

FIG 10 zeigt schematisch die Struktur eines Ausführungsbeispiels eines derart ausgebildeten Verbundwerkstoffs 28. Die Kunststoffmatrix 32 ist aus einem chemisch vernetzten Duroplast oder aus einem Thermoplast gefertigt. Beispielsweise ist die Kunststoffmatrix 32 aus einem Epoxid, Silikon, Polyurethan oder Polyetherimid gefertigt.

Der Füllstoff 29 weist elektrisch leitfähige Füllstoffpartikel 30 auf, die Gitterplätze eines von der Kunststoffmatrix 32 gebildeten Gitters mit einer Wahrscheinlichkeit besetzen, die größer als eine Perkolationsschwelle ist, oberhalb derer der Verbundwerkstoff 28 elektrisch leitfähig ist. Die Füllstoffpartikel 30 bilden also ein zusammenhängendes Partikelnetz in der Kunststoffmatrix 32, durch das der Verbundwerkstoff 28 elektrisch leitfähig ist.

Der Füllstoff 29 ist beispielsweise ein n-leitendes Metalloxid, das mit einem chemischen Element dotiert ist, dessen Ordnungszahl im Periodensystem der Elemente um Eins höher als die Ordnungszahl des Metalls des Metalloxids ist. Beispielsweise ist der Füllstoff 29 mit Antimon dotiertes Zinndioxid, ein mit Mangan dotiertes Chromoxid, ein mit Cobalt dotiertes Eisenoxid oder ein mit Nickel dotiertes Cobaltoxid.

Derartige Füllstoffe 29 bilden bei ihrer Herstellung von selbst Sauerstofffehlstellen, die als Ladungsträger-Donatoren wirken und zur guten elektrischen Leitfähigkeit des Füllstoffes 29 beitragen. Eine durch eine Überspannung verursachte Teilentladung erhitzt den Füllstoff 29 lokal und bewirkt eine lokale Erzeugung von Ozon. Durch den Temperaturanstieg und das entstandene Ozon oxidieren Oberflächenrandschichten 33 der Füllstoffpartikel 30, die Sauerstofffehlstellen aufweisen. Dadurch wird die Anzahl der Sauerstofffehlstellen im Füllstoff 29 reduziert und die elektrische Leitfähigkeit des Verbundwerkstoffs 28 wird reduziert, beziehungsweise der elektrische Widerstand des Verbundwerkstoffs 28 wird erhöht.

FIG 10 zeigt exemplarisch und schematisch eine Schnittdarstellung zweier sich berührender Füllstoffpartikel 30, die aus mit Antimon dotiertem Zinndioxid als Füllstoff 29 bestehen und durch eine Teilentladung oxidierte Oberflächenrandschichten 33 aufweisen. Ferner zeigt FIG 10 Verläufe einer oberen Valenzbandgrenze E_{V} eines Valenzbandes, einer unteren Leitungsbandgrenze E_{L} eines Leitungsbandes und einer Fermienergie E_{F} des Füllstoffs 29 entlang der Füllstoffpartikel 30. Durch die Oxidation der Füllstoffpartikel 30 steigen die obere Valenzbandgrenze E_{V} und die untere Leitungsbandgrenze E_{L} in einem Kontaktbereich 34 an, in dem die Oberflächenrandschichten 33 der Füllstoffpartikel 30 aneinandergrenzen. In dem Kontaktbereich 34 bildet sich daher eine Potentialbarriere für Elektronen 35 in dem Leitungsband, die den elektrischen Widerstand des Verbundwerkstoffes 28 erhöht.

Statt eines der oben genannten Materialien kann der Füllstoff 29 aber auch ein anderes Material sein, beispielsweise ein n-leitendes Metalloxid ohne Dotierung, ein mit Fluor oder Indium dotiertes n-leitendes Metalloxid, beschichteter oder unbeschichteter Glimmer, Quarzmehl, Ruß, Graphit oder/und Metall, beispielsweise Kupfer. Im Falle, dass der Füllstoff 29 Kupfer ist, sind die Füllstoffpartikel 30 beispielsweise Kupferflakes. Füllstoffpartikel 30 aus Ruß, Graphit oder Metall bilden bei Teilentladungen keine Oberflächenrandschichten 33 der oben beschriebenen Art, sondern oxidieren bei Teilentladungen und verlieren dadurch ihre elektrische Leitfähigkeit, so dass sich der elektrische Widerstand des Verbundwerkstoffes 28 erhöht.

Alternativ können die Leiterbahnen 18 statt aus einem der oben genannten Verbundwerkstoffe 28 aus einem elektrisch leitfähigen Kunststoff, beispielsweise aus Polyanilin (PANI) oder aus Poly(3,4-ethylendioxythiophen)-Polystyrolsulfonat (PEDOT:PSS), gefertigt sein, dessen elektrische Leitfähigkeit durch Teilentladungen reduziert oder zerstört wird.

Die Leiterbahnen 18 der Nutauskleidung, insbesondere des Nutkastens 14 und/oder der Phasentrenner sind derart ausgebildet und angeordnet, dass eine vorgegebene Überspannung aufgrund z.B. einer Teilentladung, zwischen unterschiedlichen Potentialen, die den elektrischen Widerstand der Leiterbahn 18 auf einen zu der Überspannung korrespondierenden Widerstandswert ändert. Die unterschiedlichen Potentiale können zwischen den elektrischen Leitern unterschiedlicher Phasen, unterschiedlicher Windungen einer Spule oder zwischen einer spannungsführenden Leiter und einer geerdeten Komponente der dynamoelektrischen Maschine 1, wie z.B. dem Blechpaket 10 des Stators 8 vorhanden sein. Um die Überspannung nachzuweisen, wird der elektrische Widerstand der Leiterbahn 18 gemessen und aufgrund einer Widerständsänderung wird auf die Überspannung geschlossen.

Die Erfindung ist auch bei anderen elektrischen Maschinen, wie Transformatoren einsetzbar oder wo sonst noch elektrische TE auftreten, die zu detektieren sind.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Dadurch können im laufenden Betrieb der Maschine rechtzeitig TE-Überspannungen erkannt werden, die zu Schädigungen der Isolierungen des Wicklungssystems und schließlich zu einem Totalausfall der Maschine führen können.

Die Leiterbahnen 18 auf dem Leiterbahnträger 27 sind dabei explizit nicht mit dem elektrischen Potential - also den Spulen des Wicklungssystems 13 oder dem geerdeten Blechpaket 10 des Stators 8 elektrisch leitend verbunden. Die Messung erfolgt also auf schwebendem Potential.

## Patentansprüche

1. Stator (8) und/oder Rotor (9) einer dynamoelektrischen Maschine (1), mit einem in Nuten (16) eines elektromagnetisch leitfähigen Körpers (10) angeordneten, insbesondere mehrphasigen Wicklungssystem (13), das an den Stirnseiten des jeweiligen elektromagnetisch leitfähigen Körpers (10) Wicklungsköpfe (7) ausbildet,
wobei in den Nuten (16) und/oder in dem Wickelkopf (7) zumindest abschnittsweise ein Isolationsmaterial vorgesehen ist, wobei das Isolationsmaterial einen Leiterbahnträger (27) aufweist, der in vorgebbaren Abschnitten einen Verbundwerkstoff (28) mit frequenzabhängigem Widerstandsverhalten vorsieht, um eine spannungsmäßige Überbeanspruchung, insbesondere Teilentladungen in dem Wicklungssystem (13) vor allem im Nut- und/oder Wickelkopfbereich erfassbar zu machen.

2. Stator (8) und/oder Rotor (9) einer dynamoelektrischen Maschine (1) nach Anspruch 1, **dadurch gekennzeichnet, dass** das Isolationsmaterial als Auskleidung der Nuten (16) und/oder als Phasentrenner im Wickelkopf (7) vorgesehen ist.

3. Stator (8) und/oder Rotor (9) einer dynamoelektrischen Maschine (1) nach Anspruch 1 oder 2, **dadurch gekennzeichnet, dass** die vorgebbaren Abschnitte als Leiterbahnen (18) ausgeführt sind, die jeweils eine ununterbrochene Verbindung zwischen zumindest zwei Kontaktpads (19) bilden.

4. Stator (8) und/oder Rotor (9) einer dynamoelektrischen Maschine (1) nach einem der vorhergehenden Ansprüche, **dadurch gekennzeichnet, dass** insbesondere an den axialen Rändern in vorgebbaren Bereichen der Leiterbahnträger (27), insbesondere im Bereich zumindest einer Stirnseite über die Kontaktpads (19) Widerstandsänderungen erfassbar sind.

5. Stator (8) und/oder Rotor (9) einer dynamoelektrischen Maschine (1) nach einem der vorhergehenden Ansprüche, , **dadurch gekennzeichnet, dass** die Leiterbahnen (18) auf den Leiterbahnträger (27) eine vorgebbare Leiterbahnstruktur aufweisen, die insbesondere geradlinig oder mäandernd verlaufen.

6. Stator (8) und/oder Rotor (9) einer dynamoelektrischen Maschine (1) nach einem der vorhergehenden Ansprüche, , **da- durch gekennzeichnet**, dass die Leiterbahnen (18) aus einem Verbundwerkstoff (28) gefertigt sind, der eine elektrisch nichtleitende Kunststoffmatrix (32) und einen darin eingebetteten Füllstoff (29) aufweist, durch den der Verbundwerkstoff (28) elektrisch leitfähig ist.

7. Stator (8) und/oder Rotor (9) einer dynamoelektrischen Maschine (1) nach Anspruch 6, **dadurch gekennzeichnet, dass** der Füllstoff (29) elektrisch leitfähige Füllstoffpartikel (30) aufweist, die Gitterplätze eines von der Kunststoffmatrix (32) gebildeten Gitters mit einer Wahrscheinlichkeit besetzen, die größer als eine Perkolationsschwelle ist, oberhalb derer der Verbundwerkstoff (28) elektrisch leitfähig ist, wobei die elektrische Leitfähigkeit von Füllstoffpartikeln (30) durch eine auf die Füllstoffpartikel (30) einwirkende Teilentladung reduziert wird.

8. Stator (8) und/oder Rotor (9) einer dynamoelektrischen Maschine (1) nach einem der Ansprüche 6 oder 7, **dadurch gekennzeichnet, dass** der Füllstoff (29) n-leitendes Metalloxid, beschichteten oder unbeschichteten Glimmer, Quarzmehl, Ruß, Graphit oder/und Metall enthält.

9. Stator (8) und/oder Rotor (9) einer dynamoelektrischen Maschine (1) nach einem der Ansprüche 6 bis 8, **dadurch gekennzeichnet, dass** der Füllstoff (29) mit Antimon dotiertes Zinndioxid oder/und mit Fluor oder Indium dotiertes Zinnoxid enthält.

10. Stator (8) und/oder Rotor (9) einer dynamoelektrischen Maschine (1) nach einem der Ansprüche 6 bis 9, **dadurch gekennzeichnet, dass** die Kunststoffmatrix (32) aus einem chemisch vernetzten Duroplast oder aus einem Thermoplast gefertigt ist.

11. Stator (8) und/oder Rotor (9) einer dynamoelektrischen Maschine (1) nach einem der vorhergehenden Ansprüche, **dadurch gekennzeichnet, dass** die Leiterbahnen (18) aus einem elektrisch leitfähigen Kunststoff gefertigt sind.

12. Stator (8) und/oder Rotor (9) einer dynamoelektrischen Maschine (1) nach einem der vorhergehenden Ansprüche, **dadurch gekennzeichnet, dass** die Leiterbahnen (18) aus Polyanilin oder aus Poly(3,4-ethylen-dioxythiophen)-Polystyrolsulfonat gefertigt sind.

13. Stator (8) und/oder Rotor (9) einer dynamoelektrischen Maschine (1) nach einem der vorhergehenden Ansprüche, **dadurch gekennzeichnet, dass** die Leiterbahnen (18) jeweils eine Dicke von etwa 100 um und einen elektrischen Flächenwiderstand, der vor einer Teilentladung höchstens 100 kΩ beträgt, aufweisen.

14. Verfahren zur Teilentladungsmessung eines Stators (8) und/oder eines Rotors (9) einer dynamoelektrischen Maschine (1), mit einem in Nuten (16) eines elektromagnetisch leitfähigen Körpers (10) angeordneten, insbesondere mehrphasigen Wicklungssystem (13), das an den Stirnseiten des jeweiligen elektromagnetisch leitfähigen Körpers (10) Wicklungsköpfe (7) ausbildet,
wobei in den Nuten (16) und/oder in dem Wickelkopf (7) zumindest abschnittsweise ein Isolationsmaterial vorgesehen ist, wobei das Isolationsmaterial einen Leiterbahnträger (27) aufweist, der in vorgebbaren Abschnitten einen Verbundwerkstoff (28) mit frequenzabhängigem Widerstandsverhalten vorsieht, um eine spannungsmäßige Überbeanspruchung, insbesondere Teilentladungen in dem Wicklungssystem in diesem Bereich (Nut/ Wickelkopf) erfasst wird.

15. Verfahren zur Teilentladungsmessung eines Stator (8) und/oder einem Rotor (9) einer dynamoelektrischen Maschine (1) nach Anspruch 14, **dadurch gekennzeichnet, dass** im Betrieb der dynamoelektrischen Maschine (1) zumindest einer Phasen des Motors in vorgebbaren Zeitabständen ein aufmoduliertes Signal aufgegeben wird, wobei durch die Leiterbahnstruktur vorgegebene Antennenstruktur bei TEs eine Resonanzänderung erfährt, indem durch die TE der Leiterbahnstruktur partiell hochohmig wird und dadurch erfasst wird.

16. Verfahren zur Teilentladungsmessung eines Stator (8) und/oder einem Rotor (9) einer dynamoelektrischen Maschine (1) nach Anspruch 14 oder 15, **dadurch gekennzeichnet, dass** die Messung auf schwebendem Potential erfolgt.
